# EUROPEAN PATENT APPLICATION

(11) **EP 4 598 327 A1**
(43) Date of publication of application: **06.08.2025**
(21) Application number: 23874316.5
(22) Date of filing: 28.09.2023
(51) Int. Cl.: H10K 85/50

(54) **PEROVSKITE SOLAR CELL AND PREPARATION METHOD THEREFOR, AND ELECTRIC DEVICE**

(30) Priority: 08.10.2022 WO PCT/CN2022/123787
(71) Applicant: Contemporary Amperex Technology (Hong Kong) Limited, Central (HK)
(72) Inventor: TU, Bao, Ningde, Fujian 352100 (CN); LIANG, Weifeng, Ningde, Fujian 352100 (CN); SU, Shuojian, Ningde, Fujian 352100 (CN); GUO, Wenming, Ningde, Fujian 352100 (CN); GUO, Yongsheng, Ningde, Fujian 352100 (CN); CHEN, Guodong, Ningde, Fujian 352100 (CN)
(74) Representative: Gong, Jinping
(86) International application number: PCT/CN2023/122855
(87) International publication number: WO 2024/074124

(57) **Abstract**

The present application relates to a perovskite solar cell and a preparation method thereof, and an electrical apparatus. The perovskite solar cell includes a transparent electrode, a first functional layer, a perovskite layer, a second functional layer and a second electrode layer which are stacked, wherein the perovskite layer includes a three-dimensional perovskite layer and a two-dimensional perovskite layer which are stacked, the surface of the three-dimensional perovskite layer in contact with the first functional layer being a first surface, and the remaining surfaces constituting a second surface, and the two-dimensional perovskite layer covers the entire second surface.

## Description

### CROSS-REFERENCE

The present application refers to the patent application No. PCT/CN2022/123787 filed on October 08, 2022 and entitled "PEROVSKITE SOLAR CELL AND PREPARATION METHOD THEREOF, AND ELECTRICAL APPARATUS", which is incorporated into the present application by reference in its entirety.

### TECHNICAL FIELD

The present application relates to the technical field of solar cells, and in particular, to a perovskite solar cell and a preparation method thereof, and an electrical apparatus.

### BACKGROUND

Perovskite solar cells are solar cells that use perovskite-type organic metal halide semiconductors as light-absorbing materials. They belong to the third generation of solar cells and are also called new concept solar cells.

Three-dimensional-two-dimensional combined perovskite solar cells refer to perovskite solar cells where the light-absorbing layer contains two-dimensional perovskite and three-dimensional perovskite structures that are stacked. They combine the advantages of excellent stability of two-dimensional perovskite and excellent efficiency of three-dimensional perovskite, and have therefore become one of the current research hotspots.

### SUMMARY OF THE INVENTION

The present application is conducted in view of the above problems, and its purpose is to provide a perovskite solar cell and a preparation method thereof, and an electrical apparatus.

A first aspect of the present application provides a perovskite solar cell, including a transparent electrode, a first functional layer, a perovskite layer, a second functional layer and a second electrode layer which are stacked, wherein the perovskite layer includes a three-dimensional perovskite layer and a two-dimensional perovskite layer which are stacked, the surface of the three-dimensional perovskite layer in contact with the first functional layer being a first surface, and the remaining surfaces constituting a second surface, and the two-dimensional perovskite layer covers the entire second surface.

The two-dimensional perovskite layer in the above-mentioned perovskite solar cell covers all surfaces (second surface) except the surface in contact with the first functional layer (first surface), effectively reducing the formation of defects, reducing the action sites of degradation such as oxygen and water, and improving the stability of the device.

In some embodiments, the two-dimensional perovskite layer is of a continuous structure.

In some embodiments, the general structural formula of the active material in the three-dimensional perovskite layer is ABX₃or A₂CDX₆; the general structural formula of the active material in the two-dimensional perovskite layer is A'BX₃ or A'₂CDX₆;
the A' ion and the A ion comprise one or more monovalent cations, the B ion comprises one or more divalent metal cations, the C ion and the D ion comprise one or more monovalent metal cations and trivalent metal cations, respectively, and the X ion comprises one or more monovalent anions;
wherein the ionic radius of at least one monovalent cation in the A' ion is larger than the ionic radius of the monovalent cation in the A ion.

In some embodiments, the thickness ratio of the two-dimensional perovskite layer to the three-dimensional perovskite layer is (0.2-10):100. The thickness ratio of the two-dimensional perovskite layer to the three-dimensional perovskite layer is within the above range. The thickness of the two-dimensional perovskite can fully cover the second surface of the three-dimensional perovskite layer, thereby improving the stability of the device, while making the proportion of the two-dimensional perovskite within a suitable range, thus improving the device efficiency.

In some embodiments, the two-dimensional perovskite layer has a thickness of 1-50 nm. It is determined by the roughness of the three-dimensional perovskite surface. The thickness of the two-dimensional perovskite layer is within the above range, which can, on the one hand, achieve complete coverage of the second surface of the three-dimensional perovskite layer, and on the other hand, improve the device efficiency.

In some embodiments, the three-dimensional perovskite layer has a thickness of 300-2000 nm. The thickness of the three-dimensional perovskite layer is within the above range, which can make the device current within an appropriate range, thereby enhancing the carrier transport capacity and improving the device efficiency.

In some embodiments, the A' ion comprises organic amine ions. This can further improve the uniformity of the two-dimensional perovskite layer.

In some embodiments, the A' ion has the following structural features: (R)₄N⁺, wherein R each independently comprises H, at least one R₀ substituted or unsubstituted C1-C20 alkyl, C1-C20 alkenyl, C3-C10 cycloalkyl, R₀C(O)-, R₀C(O)O-, R₀S(O)₂-, thiol, sulfonic acid group, phosphoric acid group or C6-C10 aryl, wherein R₀ each independently comprises: H, C1-C10 alkyl, C6-C10 aryl, halogen-substituted C6-C10 aryl, C1-C5 alkyl-substituted C6-C10 aryl, halogen, C3-C10 cycloalkyl or boronic acid group.

In some embodiments, the A ion comprises one or more of organic amine ions, Li⁺, Na⁺, K⁺, Rb⁺ and Cs⁺; optionally, the A ion comprises one or more of organic amine ions and Cs⁺.

In some embodiments, the B ion comprises one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, and Ni²⁺. Further, the B ion comprises one or both of Pb²⁺ and Sn²⁺.

In some embodiments, the C ion comprises one or more of Cs⁺, Ag⁺, K⁺, and Ru⁺.

In some embodiments, the D ion comprises one or more of Bi³⁺, Ni³⁺, Fe³⁺, and Cu³⁺.

In some embodiments, the X ion comprises one or more of F⁻, Cl⁻, Br⁻ and I⁻. Further, the X ion comprises one or more of Cl⁻, Br⁻and I⁻. Further, the X ion comprises one or both of Br⁻ and I⁻

In some embodiments, the active material of the three-dimensional perovskite layer comprises one or more of CH₃NH₃PbI₃(abbreviated as MAPbI₃), CH(NH₂)₂PbI₃(abbreviated as FAPbI₃), FA_{0.83}Cs_{0.17}PbI₃(abbreviated as CsFA), CsPbI₃, CsPbI₂Br and CsPbIBr₂.

In some embodiments, the active material of the two-dimensional perovskite layer comprises one or more of (PEA)₂PbI₃, (PBA)₂PbI₃, (OAm)₂PbI₃, (mF-PEA)₂PbI₃, and (PD)₂PbI₃.

A second aspect of the present application provides a method for preparing a perovskite solar cell, comprising the steps of:
preparing a first functional layer on the surface of a transparent electrode;
preparing a perovskite layer on the surface of the first functional layer, wherein the perovskite layer comprises a three-dimensional perovskite layer and a two-dimensional perovskite layer which are stacked, the surface of the three-dimensional perovskite layer in contact with the first functional layer is a first surface, the remaining surfaces constitute a second surface, and the two-dimensional perovskite layer covers the entire second surface;
preparing a second functional layer on the surface of the perovskite layer; and
preparing a second electrode layer on the surface of the second functional layer.

In some embodiments, the method for preparing the perovskite layer comprises the following steps:
preparing a three-dimensional perovskite mother layer on the surface of the first functional layer, wherein the general structural formula of the active material of the three-dimensional perovskite mother layer is ABX₃ or A₂CDX₆;
performing solvent treatment on the surface of the three-dimensional perovskite mother layer corresponding to the second surface by means of a mixed solvent; and
reacting the three-dimensional perovskite mother layer after solvent treatment with a compound providing A'ions to generate the two-dimensional perovskite layer, wherein the general structural formula of the active material of the two-dimensional perovskite layer is general structural formula of A'BX₃or A'₂CDX₆;
the A' ion and the A ion comprise one or more monovalent cations, the B ion comprises one or more divalent metal cations, the C ion and the D ion comprise one or more monovalent metal cations and trivalent metal cations, respectively, and the X ion comprises one or more monovalent anions;
wherein the ionic radius of at least one monovalent cation in the A' ion is larger than the ionic radius of the monovalent cation in the A ion.

The above-mentioned method for preparing a perovskite layer first dissolves and removes the A ions on the surface of the three-dimensional perovskite mother layer with the help of a mixed solvent, and then reacts the exposed BX₃ or CDX₆with a compound that provides A' ions, and the ionic radius of the A' ions is larger than the ionic radius of the A ions. The introduction of A' ions can effectively promote the formation of two-dimensional perovskite, and at the same time completely and continuously cover the second surface of the entire three-dimensional perovskite.

Meanwhile, even if the traditional method can generate a two-dimensional perovskite layer, the prepared two-dimensional perovskite layer still has problems such as poor uniformity, poor repeatability between batches, and uncontrollable thickness. The above-mentioned method for preparing a perovskite layer not only can promote the generation of the two-dimensional perovskite layer, but also can effectively improve the uniformity of the two-dimensional perovskite layer. By controlling the type, proportion, processing time, etc. of the mixed solvent, the amount of three-dimensional perovskite dissolved can be relatively controlled, thereby making the thickness of the two-dimensional perovskite layer controllable. For example, the two-dimensional perovskite can be made only in the shallow surface layer, and the main body is still the three-dimensional perovskite. In addition, the repeatability between production batches is high, and the degree of completion is high.

In addition, the preparation method of the perovskite layer will not have a negative impact on the device performance during the preparation process, and can maintain the stability of the device performance.

In some embodiments, the mixed solvent comprises a combination of a first solvent, a second solvent, and a third solvent.

Specifically, the first solvent comprises one or more solvents used for preparing a precursor solution of the three-dimensional perovskite mother layer; optionally, the first solvent comprises one or more of amine, sulfone, sulfoxide, ester and ketone solvents; further optionally, the first solvent comprises one or more of dimethylformamide (DMF), dimethyl sulfoxide (DMSO), N-methyl pyrrolidone (NMP) and γ-butyrolactone (GLB).

Specifically, the second solvent comprises a solvent that can dissolve A ions but cannot dissolve BX₂, or the second solvent comprises a solvent that can dissolve A ions but cannot dissolve CDX₄; optionally, the second solvent comprises one or more of alcohol, nitrile and ketone solvents; further optionally, the second solvent comprises one or more of isopropanol (IPA), ethanol, methanol, acetone and acetonitrile.

Specifically, the third solvent comprises one or more anti-solvents used for preparing the three-dimensional perovskite mother layer; optionally, the third solvent comprises one or more of aromatic hydrocarbon, ether and ester solvents; further optionally, the third solvent comprises one or more of chlorobenzene (CB), anisole, ethyl ether and ethyl acetate.

In some embodiments, the first solvent is 0.01% to 1% by volume of the third solvent.

When the amount of the first solvent is within the above range, a continuous two-dimensional perovskite film can be easily formed, thereby improving the stability of the device and preventing excessive dissolution of the three-dimensional perovskite, thus improving the efficiency of the device.

In some embodiments, the second solvent is 0.01% to 10% by volume of the third solvent. When the amount of the second solvent is within the above range, a continuous two-dimensional perovskite film can be formed while preventing the two-dimensional perovskite layer from being too thick, thereby further improving the device efficiency.

In some embodiments, the volume ratio of the first solvent to the second solvent is (0.1-1):1. Controlling this volume ratio can better dissolve the three-dimensional perovskite mother layer, which is conducive to the formation of a continuous two-dimensional perovskite film, improving device stability, and reducing the decrease in the overall thickness of the device. For example, some unreactive BX2 or CDX4 inside can be dissolved to reduce the overall thickness of the device and optimize the device efficiency.

In some embodiments, the solvent treatment time is 1 min to 60 min. There is a corresponding relationship between the solvent treatment time and the amount of the first solvent and the second solvent added. When the amount of the first solvent and the second solvent is large, the required time is short to prevent the loss of too many A-site cations which would result in the formation of a thick two-dimensional perovskite layer; when the amount of the first solvent and the second solvent is small, the required time is long to prevent the failure to form a continuous two-dimensional perovskite film layer.

In some embodiments, the temperature of the mixed solvent used in the solvent treatment is 20°C-30°C;

In some embodiments, the amount of the first solvent used is X µL, the thickness of the two-dimensional perovskite layer is Y nm, and X and Y satisfy 0.05<X/Y<5. Controlling the X/Y ratio can shorten the time required to reach the desired thickness of the two-dimensional perovskite layer, which is beneficial for optimizing the interface layer, improving the fill factor, and improving the uniformity and complete coverage of the two-dimensional perovskite.

In some embodiments, the condition for reacting the three-dimensional perovskite mother layer after solvent treatment with the compound providing A' ions comprises: annealing at a temperature of 50°C to 150°C; optionally, the annealing time is 20min to 40min.

In some embodiments, the compound providing A' ions comprises one or more of the following compounds and their salts: CH₃CH₂CH₂CH₂CH₂CH₂CH₂CH₂NH₂, CH₃CH₂CH₂CH₂CONH₂, CH₃CH₂CH₂CH₂COONH₂, phenethylamine, benzylamine, amphetamine, fluorophenethylamine, fluorophenethylamine iodide (F-PEAI), phenylboronic acid amine, oleylamine, octylammonium bromide, N,N-bis(2-chloroethyl)-p-toluenesulfonic acid amine and cyclopentanecarboxamide.

In a third aspect of the present application, an electrical apparatus is provided, comprising at least one of the perovskite solar cell described in the first aspect and the perovskite solar cell prepared by the preparation method described in the second aspect.

### BRIEF DESCRIPTION OF DRAWINGS

Fig. 1 is a schematic diagram of the preparation process of a perovskite layer in a perovskite solar cell according to an embodiment of the present application;
Fig. 2 is a schematic diagram of an electrical apparatus using a solar cell as the power supply according to an embodiment of the present application.

### DETAILED DESCRIPTION

The perovskite solar cell and its preparation method and the electrical apparatus of the present application are further described in detail below in conjunction with specific embodiments. The present invention may be embodied in many different forms and is not limited to the embodiments described herein. On the contrary, the purpose of providing these embodiments is to make the disclosure of the present invention more thorough and complete.

The details of one or more embodiments of the present application are set forth in the accompanying drawings and the description below. Other features, objects, and advantages of the present application will be apparent from the description and drawings, and from the claims.

Unless otherwise defined, all technical and scientific terms used herein have the same meanings as commonly understood by those skilled in the art of the present application. The terms used in the description of the present invention herein is only for the purpose of describing specific embodiments, and is not intended to limit the present invention.

"Ranges" disclosed in the present application are defined in the form of lower limits and upper limits, a given range is defined by the selection of a lower limit and an upper limit, and the selected lower limit and upper limit define boundaries of a particular range. A range defined in this manner may be inclusive or exclusive of end values, and may be arbitrarily combined, that is, any lower limit may be combined with any upper limit to form a range. For example, if the ranges of 60-120 and 80-110 are listed for a particular parameter, it is understood that the ranges of 60-110 and 80-120 are also contemplated. Additionally, if the minimum range values 1 and 2 are listed, and if the maximum range values 3, 4 and 5 are listed, the following ranges are all contemplated: 1-3, 1-4, 1-5, 2- 3, 2-4 and 2-5. In the present application, unless stated otherwise, the numerical range "a-b" represents an abbreviated representation of any combination of real numbers between a to b, where both a and b are real numbers. For example, the numerical range "0-5" means that all the real numbers between "0-5" have been listed herein, and "0-5" is just an abbreviated representation of combinations of these numerical values. In addition, when a parameter is expressed as an integer greater than or equal to 2, it is equivalent to disclosing that the parameter is, for example, an integer of 2, 3, 4, 5, 6, 7, 8, 9, 10, 11, 12, and the like.

Unless otherwise specified, all embodiments and optional embodiments of the present application may be combined with each other to form new technical solutions.

Unless otherwise specified, all technical features and optional technical features of the present application may be combined with each other to form new technical solutions.

Unless otherwise specified, all steps of the present application may be performed sequentially or randomly, and preferably sequentially. For example, the method comprises steps (a) and (b), meaning that the method may comprise steps (a) and (b) performed sequentially, or may comprise steps (b) and (a) performed sequentially. For example, the reference to the method may further comprise step (c), meaning that step (c) may be added to the method in any order. For example, the method may comprise steps (a), (b) and (c), or may further comprise steps (a), (c) and (b), or may further comprise steps (c), (a) and (b), and the like.

Unless otherwise specifically stated, the terms "comprising" and "including" mentioned in the present application may be open-ended, or may be closed-ended. For example, the "comprising" and "including" may indicate that it is also possible to include or comprise other components not listed, and it is also possible to include or comprise only the listed components.

Unless otherwise specifically stated, the term "or" is inclusive in the present application. For example, the phrase "A or B" means "A, B, or both A and B." More specifically, the condition "A or B" is satisfied under any one of the following conditions: A is true (or present) and B is false (or absent); A is false (or absent) and B is true (or present); or both A and B are true (or present).

In the present application, the term "aryl" refers to an aromatic hydrocarbon group derived from an aromatic ring compound by removing a hydrogen atom. It can be a monocyclic aromatic group, a condensed aromatic group, or a polycyclic aromatic group. For polycyclic rings, at least one is an aromatic ring system. For example, "C6-C10 aryl" refers to an aryl group containing 6 to 10 carbon atoms, and each occurrence thereof can be independently a C6 aryl group, a C7 aryl group, a C8 aryl group, a C9 aryl group or a C10 aryl group.

In the present application, the term "alkyl" refers to a monovalent residue formed by the loss of a hydrogen atom from a saturated hydrocarbon containing a primary (normal) carbon atom, a secondary carbon atom, a tertiary carbon atom, a quaternary carbon atom, or a combination thereof. Phrases containing this term, for example, "C1-C20 alkyl" means an alkyl group containing 1 to 10 carbon atoms, and each occurrence can independently be C1 alkyl, C2 alkyl, C3 alkyl, C4 alkyl, C5 alkyl, C6 alkyl, C7 alkyl, C8 alkyl, C9 alkyl, C10 alkyl, C12 alkyl, C15 alkyl, C20 alkyl. Suitable examples include, but are not limited to, methyl(Me, -CH₃), ethyl(Et, - CH₂CH₃), 1-propyl(n-Pr, n-propyl, -CH₂CH₂CH₃), 2-propyl(i-Pr, i-propyl, -CH(CH₃)₂), 1-butyl(n-Bu, n-butyl, -CH₂CH₂CH₂CH₃), 2-methyl-1-propyl(i-Bu, i-butyl, -CH₂CH(CH₃)₂), 2-butyl(s-Bu, s-butyl, -CH(CH₃)CH₂CH₃), 2-methyl-2-propyl(t-Bu, t-butyl, -C(CH₃)₃), 1-pentyl(n-pentyl, - CH₂CH₂CH₂CH₂CH₃), 2-pentyl(-CH(CH₃)CH₂CH₂CH₃), 3-pentyl(-CH(CH₂CH₃)₂), 2-methyl-2-butyl(-C(CH₃)₂CH₂CH₃), 3-methyl-2-butyl(-CH(CH₃)CH(CH₃)₂), 3-methyl-1-butyl(-CH₂CH₂CH(CH₃)₂), 2-methyl-1-butyl(-CH₂CH(CH₃)CH₂CH₃), 1-hexyl(-CH₂CH₂CH₂CH₂CH₂CH₃), 2-hexyl(-CH(CH₃)CH₂CH₂CH₂CH₃), 3-hexyl(-CH(CH₂CH₃)(CH₂CH₂CH₃)), 2-methyl-2-pentyl(-C(CH₃)₂CH₂CH₂CH₃), 3-methyl-2-pentyl(-CH(CH₃)CH(CH₃)CH₂CH₃), 4-methyl-2-pentyl(-CH(CH₃)CH₂CH(CH₃)₂), 3-methyl-3-pentyl(-C(CH₃)(CH₂CH₃)₂), 2-methyl-3-pentyl(-CH(CH₂CH₃)CH(CH₃)₂), 2,3-dimethyl-2-butyl(-C(CH₃)₂CH(CH₃)₂), 3,3-dimethyl-2-butyl(-CH(CH₃)C(CH₃)₃ and octyl(-(CH₂)₇CH₃).

In the present application, the term "cycloalkyl" refers to a non-aromatic hydrocarbon containing ring carbon atoms, and may be a monocyclic alkyl, a spirocyclic alkyl, or a bridged cyclic alkyl. Phrases containing this term, for example, "C3-C10 cycloalkyl" refers to cycloalkyl groups containing 3 to 10 carbon atoms, and each occurrence can be independently C3 cycloalkyl, C4 cycloalkyl, C5 cycloalkyl, C6 cycloalkyl, C7 cycloalkyl, C8 cycloalkyl, C9 cycloalkyl, or C10 cycloalkyl. Suitable examples include, but are not limited to, cyclopropyl, cyclobutyl, cyclopentyl, cyclohexyl, and cycloheptyl. Additionally, the "cycloalkyl" group may contain one or more double bonds. Representative examples of cycloalkyl groups containing double bonds include cyclopentenyl, cyclohexenyl, cyclohexadienyl, and cyclobutadienyl.

In the present application, the term "three-dimensional perovskite" refers to a perovskite having a three-dimensional crystal structure with a BX6 octahedral framework where A-site cations occupy vertex positions.

In the present application, the term "two-dimensional perovskite" refers to a perovskite in which the BX6 octahedral framework is isolated by bulky A-site cations, such as A' ions, forming a special layered structure of alternating organic and inorganic layers.

Specifically, "three-dimensional perovskite" and "two-dimensional perovskite" can be distinguished by the position of XRD peaks. Generally speaking, the XRD peaks of three-dimensional perovskite mainly appear in multiple crystal directions such as (001), (010), (111), and the main peak appears between 13-15, while the XRD peaks of two-dimensional perovskite mainly appear in one crystal direction such as (0x0)x=2/4/6/8, without obvious main peaks, and may also appear below 10.

In traditional methods, three-dimensional-two-dimensional combined perovskite solar cells are mainly prepared by reducing the dimensionality of three-dimensional perovskite. For example, one method uses hot injection synthesis to regulate the colloidal synthesis kinetics through the metal ion surface to prepare efficient quasi-two-dimensional perovskites; another method introduces organic ligands into the absorption layer of the perovskite battery to reduce the three-dimensional perovskite framework structure to a two-dimensional structure, forming a perovskite absorption layer structure with one inorganic perovskite layer and two organic ligand layers; still another method uses gradient annealing to obtain a perovskite film with a two-dimensional structure in the lower layer and a three-dimensional structure in the upper layer, which has a two-dimensional/three-dimensional planar heterojunction structure. However, the focus of these methods is on the preparation process of the perovskite layer, which has the problem of uncontrollable process and makes it difficult to improve the generation of two-dimensional perovskite in industrial applications.

In addition, there is a method to treat the surface of the three-dimensional perovskite film with saturated vapor of n-butylamine to quickly form a two-dimensional perovskite thin layer on the surface. The method is simple and the process is well controllable, the cost is low, and it is suitable for large-scale industrial applications. Although this method overcomes the problem of uncontrollable process to a certain extent, it cannot ensure the generation of two-dimensional perovskite. Even if two-dimensional perovskite is generated, it is difficult to form a continuous two-dimensional perovskite layer structure. In particular, the probability of generating two-dimensional perovskite around three-dimensional perovskite is low, and complete coverage of three-dimensional perovskite cannot be achieved.

The present application provides a perovskite solar cell, including a transparent electrode, a first functional layer, a perovskite layer, a second functional layer and a second electrode layer which are stacked, wherein the perovskite layer includes a three-dimensional perovskite layer and a two-dimensional perovskite layer which are stacked, the surface of the three-dimensional perovskite layer in contact with the first functional layer being a first surface, and the remaining surfaces constituting a second surface, and the two-dimensional perovskite layer covers the entire second surface.

The two-dimensional perovskite layer in the above-mentioned perovskite solar cell covers all surfaces (second surface) except the surface in contact with the first functional layer (first surface), effectively reducing the formation of defects, reducing the action sites of degradation such as oxygen and water, and improving the stability of the device.

In addition, the above-mentioned two-dimensional perovskite layer has good uniformity and high film layer quality, which can effectively reduce the interfacial contact resistance between layers and improve the fill factor of the device.

Furthermore, the two-dimensional perovskite layer wraps the second surface and contacts the first functional layer to cover the three-dimensional perovskite layer.

In some embodiments, the two-dimensional perovskite layer is of a continuous structure, thereby forming a continuous, uninterrupted layer structure that completely covers the second surface.

In some embodiments, the general structural formula of the active material in the three-dimensional perovskite layer is ABX₃or A₂CDX₆; the general structural formula of the active material in the two-dimensional perovskite layer is A'BX₃or A'₂CDX₆;
the A' ion and the A ion comprise one or more monovalent cations, the B ion comprises one or more divalent metal cations, the C ion and the D ion comprise one or more monovalent metal cations and trivalent metal cations, respectively, and the X ion comprises one or more monovalent anions;
wherein the ionic radius of at least one monovalent cation in the A' ion is larger than the ionic radius of the monovalent cation in the A ion.

As an example, the ionic radius can be calculated by first principles based on density functional theory (DET).

In some embodiments, the A' ion comprises organic amine ions. This can further improve the uniformity of the two-dimensional perovskite layer. Specifically, the A' ion has the following structural features: (R)₄N⁺, wherein R each independently includes H, at least one R₀ substituted or unsubstituted C1-C20 alkyl, C1-C20 alkenyl, C3-C10 cycloalkyl, R₀C(O)-, R₀C(O)O-, R₀S(O)₂-, thiol, sulfonic acid group, phosphoric acid group or C6-C10 aryl. Here, R₀each independently includes: H, C1-C10 alkyl, C6-C10 aryl, halogen-substituted C6-C10 aryl, C1-C5 alkyl-substituted C6-C10 aryl, halogen, C3-C10 cycloalkyl or boronic acid group.

In some embodiments, the A' ion comprises one or more of phenethylamine (PEA) ions, fluorophenethylamine (mF-PEA) ions, phenylboronic acid amine (PBA) ions, and oleylamine (OAm) ions. It can be understood that the "m" in "mF-PEA" means that F and PEA are in the meta position on the benzene ring.

In some embodiments, the A ion comprises one or more of organic amine ions, Li⁺, Na⁺, K⁺, Rb⁺ and Cs⁺; optionally, the A ion comprises one or more of organic amine ions and Cs⁺.

In some embodiments, the B ion comprises one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, and Ni²⁺. Further, the B ion comprises one or both of Pb²⁺ and Sn²⁺.

In some embodiments, the C ion comprises one or more of Cs⁺, Ag⁺, K⁺, and Ru⁺.

In some embodiments, the D ion comprises one or more of Bi³⁺, Ni³⁺, Fe³⁺, and Cu³⁺.

In some embodiments, the X ion comprises one or more of F⁻, Cl⁻, Br⁻ and I⁻. Further, the X ion comprises one or more of Cl⁻, Br⁻and I⁻. Further, the X ion comprises one or both of Br⁻ and I-.

In some embodiments, the active material of the three-dimensional perovskite layer includes one or more of CH₃NH₃PbI₃(abbreviated as MAPbI₃), CH(NH₂)₂PbI₃(abbreviated as FAPbI₃), FA_{0.83}Cs_{0.17}PbI₃(abbreviated as CsFA), CsPbI₃, CsPbI₂Br and CsPbIBr₂.

In some embodiments, the active material of the two-dimensional perovskite layer includes one or more of (PEA)₂PbI₃, (PBA)₂PbI₃, (OAm)₂PbI₃, (mF-PEA)₂PbI₃, and (PD)₂PbI₃.

In some embodiments, the thickness ratio of the two-dimensional perovskite layer to the three-dimensional perovskite layer is (0.2-10):100. The thickness ratio of the two-dimensional perovskite layer to the three-dimensional perovskite layer is within the above range. The thickness of the two-dimensional perovskite can fully cover the second surface of the three-dimensional perovskite layer, thereby improving the stability of the device, while making the proportion of the two-dimensional perovskite within a suitable range, thus improving the device efficiency. Specifically, the thickness ratio of the two-dimensional perovskite layer to the three-dimensional perovskite layer includes but is not limited to: 0.2:100, 0.3:100, 0.4:100, 0.5:100, 0.6:100, 0.7:100, 0.8:100, 0.9:100, 1:100, 1.5:100, 1.6:100, 1.7:100, 2:100, 2.2:100, 2.4:100, 2.5:100, 2.7:100, 4:100, 5:100, 5.6:100, 6:100, 7:100, 8:100, 9:100, 10:100 or a range consisting of any two of the above values.

In some embodiments, the two-dimensional perovskite layer has a thickness of 1-50 nm. It is determined by the roughness of the three-dimensional perovskite surface. The thickness of the two-dimensional perovskite layer is within the above range, which can, on the one hand, achieve complete coverage of the second surface of the three-dimensional perovskite layer, and on the other hand, improve the device efficiency. Specifically, the thickness of the two-dimensional perovskite layer includes but is not limited to: 1nm, 2nm, 3nm, 4nm, 5nm, 6nm, 7nm, 8nm, 9nm, 10nm, 14nm, 16nm, 20nm, 23nm, 25nm, 28nm, 32nm, 35nm, 38nm, 40nm, 45nm, 50nm or a range consisting of any two of the above values. Furthermore, the thickness of the two-dimensional perovskite layer is 2-32 nm.

In some embodiments, the three-dimensional perovskite layer has a thickness of 300-2000 nm. The thickness of the three-dimensional perovskite layer is within the above range, which can make the device current within an appropriate range, thereby enhancing the carrier transport capacity and improving the device efficiency. Specifically, the thickness of the three-dimensional perovskite layer includes but is not limited to: 300nm, 350nm, 370nm, 380nm, 390nm, 400nm, 450nm, 480nm, 500nm, 520nm, 550nm, 580nm, 600nm, 620nm, 640nm, 650nm, 670nm, 680nm, 700nm, 750nm, 800nm, 850nm, 870nm, 890nm, 900nm, 950nm, 1000nm, 1200nm, 1400nm, 1500nm, 1600nm, 1700nm, 1900nm, 2000nm or a range consisting of any two of the above values.

The present application provides a method for preparing a perovskite solar cell, including the steps of:
preparing a first functional layer on the surface of a transparent electrode;
preparing a perovskite layer on the surface of the first functional layer, wherein the perovskite layer comprises a three-dimensional perovskite layer and a two-dimensional perovskite layer which are stacked, the surface of the three-dimensional perovskite layer in contact with the first functional layer is a first surface, the remaining surfaces constitute a second surface, and the two-dimensional perovskite layer covers the entire second surface;
preparing a second functional layer on the surface of the perovskite layer; and
preparing a second electrode layer on the surface of the second functional layer.

In some embodiments, the two-dimensional perovskite layer is of a continuous structure.

In some embodiments, the method for preparing the perovskite layer includes the following steps:
preparing a three-dimensional perovskite mother layer on the surface of the first functional layer, wherein the general structural formula of the active material of the three-dimensional perovskite mother layer is ABX₃or A₂CDX₆;
performing solvent treatment on the surface of the three-dimensional perovskite mother layer corresponding to the second surface by means of a mixed solvent; and
reacting the three-dimensional perovskite mother layer after solvent treatment with a compound providing A'ions to generate the two-dimensional perovskite layer, wherein the general structural formula of the active material of the two-dimensional perovskite layer is general structural formula of A'BX₃or A'₂CDX₆;
the A' ion and the A ion comprise one or more monovalent cations, the B ion comprises one or more divalent metal cations, the C ion and the D ion comprise one or more monovalent metal cations and trivalent metal cations, respectively, and the X ion comprises one or more monovalent anions;
wherein the ionic radius of at least one monovalent cation in the A' ion is larger than the ionic radius of the monovalent cation in the A ion.

The above-mentioned method for preparing a perovskite layer first dissolves and removes the A ions on the surface of the three-dimensional perovskite mother layer with the help of a mixed solvent, and then reacts the exposed BX₃or CDX₆with a compound that provides A' ions, and the ionic radius of the A' ions is larger than the ionic radius of the A ions. The introduction of A' ions can effectively promote the formation of two-dimensional perovskite, and at the same time completely and continuously cover the second surface of the entire three-dimensional perovskite.

Meanwhile, even if the traditional method can generate a two-dimensional perovskite layer, the prepared two-dimensional perovskite layer still has problems such as poor uniformity, poor repeatability between batches, and uncontrollable thickness. The above-mentioned method for preparing a perovskite layer not only can promote the generation of the two-dimensional perovskite layer, but also can effectively improve the uniformity of the two-dimensional perovskite layer. By controlling the type, proportion, processing time, etc. of the mixed solvent, the amount of three-dimensional perovskite dissolved can be relatively controlled, thereby making the thickness of the two-dimensional perovskite layer controllable. For example, the two-dimensional perovskite can be made only in the shallow surface layer, and the main body is still the three-dimensional perovskite. In addition, the repeatability between production batches is high, and the degree of completion is high.

In addition, the preparation method of the perovskite layer will not have a negative impact on the device performance during the preparation process, and can enhance the stability of the device performance.

It can be understood that the portion of the three-dimensional perovskite mother layer excluding the two-dimensional perovskite layer remains the original three-dimensional perovskite layer.

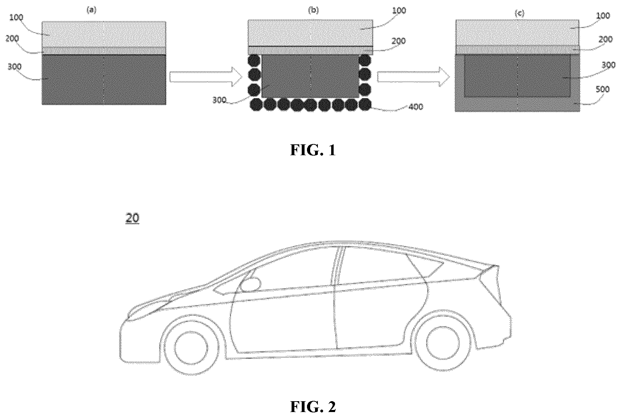

Specifically, an example of the above-mentioned preparation method of the perovskite layer can be seen in Fig. 1: Fig. 1 (a) provides a preform (including a transparent electrode 100 and a hole transport layer 200 which are stacked) prepared with a three-dimensional perovskite mother layer 300; Fig. 1 (b) uses a mixed solvent to treat the surface of the three-dimensional perovskite mother layer 300 except for the surface layer in contact with the hole transport layer, and dissolves and removes A ions in the corresponding active material to obtain a remaining material 400; Fig. 1 (c) reacts the remaining material 400 with a compound that provides A' ions to generate a two-dimensional perovskite layer 500, and at the same time, the remaining three-dimensional perovskite mother layer is the three-dimensional perovskite layer.

In some embodiments, the mixed solvent includes a combination of a first solvent, a second solvent, and a third solvent.

Specifically, the first solvent includes one or more solvents used for preparing a precursor solution of the three-dimensional perovskite mother layer; optionally, the first solvent includes one or more of amine, sulfone, sulfoxide, ester and ketone solvents; further optionally, the first solvent includes one or more of dimethylformamide (DMF), dimethyl sulfoxide (DMSO), N-methyl pyrrolidone (NMP) and γ-butyrolactone (GLB).

Specifically, the second solvent includes a solvent that can dissolve A ions but cannot dissolve BX₂, or the second solvent includes a solvent that can dissolve A ions but cannot dissolve CDX₄; optionally, the second solvent includes one or more of alcohol, nitrile and ketone solvents; further optionally, the second solvent includes one or more of isopropanol (IPA), ethanol, methanol, acetone and acetonitrile. Without limitation, the solubility of the second solvent for A ions is >0.1 mg/mL at room temperature, and the solubility of the second solvent for BX₂ or CDX₄ is <0.05 mg/mL at room temperature.

It can be understood that BX₂and CDX₄refer to materials composed of B and X, C, D and X in ABX₃, A₂CDX₆, A'BX₃ and A'₂CDX₆, i.e., precursor materials for preparing perovskite layer.

Specifically, the third solvent includes one or more anti-solvents used for preparing the three-dimensional perovskite mother layer; optionally, the third solvent includes one or more of aromatic hydrocarbon, ether and ester solvents; further optionally, the third solvent includes one or more of chlorobenzene (CB), anisole, ethyl ether and ethyl acetate.

In some embodiments, the first solvent is 0.01% to 1% by volume of the third solvent.

When the amount of the first solvent is within the above range, a continuous two-dimensional perovskite film can be easily formed, thereby improving the stability of the device and preventing excessive dissolution of the three-dimensional perovskite, thus improving the efficiency of the device. Specifically, based on the volume percentage of the third solvent, the volume percentage of the first solvent includes but is not limited to 0.01%, 0.05%, 0.08%, 0.1%, 0.12%, 0.15%, 0.2%, 0.3%, 0.4%, 0.5%, 0.6%, 0.7%, 0.8%, 0.9%, 1% or a range consisting of any two of the above values.

In some embodiments, the second solvent is 0.01% to 10% by volume of the third solvent. When the amount of the second solvent is within the above range, a continuous two-dimensional perovskite film can be formed while preventing the two-dimensional perovskite layer from being too thick, thereby further improving the device efficiency. Specifically, based on the volume percentage of the third solvent, the volume percentage of the second solvent includes but is not limited to: 0.01%, 0.05%, 0.1%, 0.2%, 0.3%, 0.4%, 0.5%, 0.6%, 0.7%, 0.8%, 0.9%, 1%, 1.5%, 2%, 5%, 8%, 9%, 10% or a range consisting of any two of the above values.

In some embodiments, the volume ratio of the first solvent to the second solvent is (0.1-1):1. Controlling this volume ratio can better dissolve the three-dimensional perovskite mother layer, which is conducive to the formation of a continuous two-dimensional perovskite film, improving device stability, and reducing the decrease in the overall thickness of the device. For example, some unreactive BX₂ or CDX₄ inside can be dissolved to reduce the overall thickness of the device and optimize the device efficiency. Specifically, the volume ratio of the first solvent to the second solvent includes but is not limited to: 0.1:1, 0.2:1, 0.3:1, 0.4:1, 0.5:1, 0.6:1, 0.7:1, 0.8:1, 0.9:1, 1:1 or a range consisting of any two of the above values.

In some embodiments, the solvent treatment time is 1 min to 60 min. There is a corresponding relationship between the solvent treatment time and the amount of the first solvent and the second solvent added. When the amount of the first solvent and the second solvent is large, the required time is short to prevent the loss of too many A-site cations which would result in the formation of a thick two-dimensional perovskite layer; when the amount of the first solvent and the second solvent is small, the required time is long to prevent the failure to form a continuous two-dimensional perovskite film layer. Specifically, the time for solvent treatment includes but is not limited to: 1 min, 5 min, 10 min, 15 min, 20 min, 30 min, 35 min, 40 min, 45 min, 50 min, 55 min, 60 min or a range consisting of any two of the above values.

In some embodiments, the temperature of the mixed solvent used in the solvent treatment is 20°C-30°C (room temperature).

In some embodiments, the amount of the first solvent used is X µL, the thickness of the two-dimensional perovskite layer is Y nm, and X and Y satisfy 0.05<X/Y<5. Controlling the X/Y ratio can shorten the time required to reach the desired thickness of the two-dimensional perovskite layer, which is beneficial for optimizing the interface layer, improving the fill factor, and improving the uniformity and complete coverage of the two-dimensional perovskite. Specifically, the X/Y ratio includes but is not limited to: 0.05, 0.08, 0.1, 0.15, 0.2, 0.25, 0.3, 0.35, 0.4, 0.45, 0.5, 0.6, 0.7, 0.8, 1, 1.5, 2, 3, 4, 5 or a range consisting of any two of the above values.

In some embodiments, the condition for reacting the three-dimensional perovskite mother layer after solvent treatment with the compound providing A' ions includes: annealing at a temperature of 50°C to 150°C; optionally, the annealing time is 20min to 40min.

In some embodiments, the compound providing A' ions includes one or more of the following compounds and their salts: CH₃CH₂CH₂CH₂CH₂CH₂CH₂CH₂NH₂, CH₃CH₂CH₂CH₂CONH₂, CH₃CH₂CH₂CH₂COONH₂, phenethylamine, benzylamine, amphetamine, fluorophenethylamine, fluorophenethylamine iodide (F-PEAI), phenylboronic acid amine, oleylamine, octylammonium bromide, N,N-bis(2-chloroethyl)-p-toluenesulfonic acid amine and cyclopentanecarboxamide. Without limitation, the salts include halide salts or acid salts of the aforementioned compounds.

In addition, the technical solutions of the three-dimensional perovskite layer and the two-dimensional perovskite layer in the above preparation method are the same as those of the aforementioned perovskite solar cell, which will not be repeated here.

It can be understood that perovskite solar cells include regular and inverted types. For the regular type, the perovskite solar cell includes a transparent electrode and an electron transport layer, a perovskite layer, a hole transport layer and a second electrode layer that are stacked in sequence on the transparent electrode. For the inverted type, the perovskite solar cell includes a transparent electrode and a hole transport layer, a perovskite layer, an electron transport layer, and a second electrode layer that are stacked in sequence on the transparent electrode.

In some embodiments, the band gap of the perovskite layer is 1.20 eV to 2.30 eV. The band gap can be obtained by measuring an ultraviolet absorption spectrum to obtain an ultraviolet absorption curve, and then calculating the band gap using the Tauc equation.

In some embodiments, the thickness of the perovskite layer is 400nm to 1000nm.

Without limitation, the transparent electrode includes a transparent conductive glass substrate, and materials thereof may include FTO, ITO, AZO, BZO, IZO, and the like.

Without limitation, the material of the electron transport layer may include at least one of the following materials and their derivatives and materials obtained by doping or passivation: [6,6]-phenyl C₆₁butyric acid methyl ester (PC₆₁BM), [6,6]-phenyl C₇₁ butyric acid methyl ester (PC₇₁BM), fullerene C60 (C60), fullerene C70 (C70), tin dioxide (SnO₂), zinc oxide (ZnO), etc.

Without limitation, the hole transport layer may include at least one of the following materials and their derivatives and materials obtained by doping or passivation: poly[bis(4-phenyl)(2,4,6-trimethylphenyl)amine] (PTAA), poly-3-hexylthiophene (P3HT), triphenylamine (H101) with triptycene as the core, 3, 4-ethylenedioxythiophene-methoxytriphenylamine (EDOT-OMeTPA), N-(4-aniline)carbazole-spirobifluorene (CzPAF-SBF), poly(3,4-ethylenedioxythiophene): polystyrene sulfonate (PEDOT:PSS), polythiophene, nickel oxide (NiOx), molybdenum oxide (MoO3), cuprous iodide (CuI), cuprous oxide (CuO), etc.

Without limitation, the material of the second electrode layer may include organic, inorganic or organic-inorganic hybrid conductive materials, for example, Ag, Cu, C, Au, Al, ITO, AZO, BZO, IZO, etc.

Specifically, the perovskite solar cell is of regular type, and its preparation method includes the following steps:
Step 1: etching and cleaning the transparent electrode and drying;
Step 2: preparing an electron transport layer on the transparent electrode;
Step 3: preparing the perovskite layer on the electron transport layer;
Step 4: preparing a hole transport layer on the perovskite layer; and
Step 5: preparing a second electrode layer on the hole transport layer.

Specifically, the perovskite solar cell is of inverted type, and its preparation method includes the following steps:
Step 1: etching and cleaning the transparent electrode and drying;
Step 2: preparing a hole transport layer on the transparent electrode;
Step 3: preparing the perovskite layer on the electron transport layer;
Step 4: preparing the electron transport layer on the perovskite layer; and
Step 5: preparing a second electrode layer on the hole transport layer.

The present application provides an electrical apparatus, comprising at least one of the above-mentioned perovskite solar cell and the perovskite solar cell prepared by the above-mentioned solar cell preparation method.

In some of the embodiments, the above-mentioned solar cell may be used as a power source of the electrical apparatus, or may be used as an energy storage unit of an electrical device.

Furthermore, the above-mentioned electrical apparatus may include mobile devices, such as mobile phones, laptop computers, etc., electric vehicles, electric trains, ships and satellites, energy storage systems, etc., but are not limited thereto.

Fig. 2 is an example of an electrical apparatus. This electrical apparatus 20 is an all-electric vehicle, a hybrid electric vehicle, or a plug-in hybrid electric vehicle, etc.

As another example, the electrical apparatus may be a mobile phone, a tablet, a laptop, etc.

### Examples

Examples of the present application will be described below. The examples described below are exemplary and only used to explain the present application, and are not to be construed as limiting the present application. Where specific techniques or conditions are not specified in the examples, the techniques or conditions described in the literature of the art or the product specifications are followed. Where manufacturers are not specified, the reagents or instruments used are conventional products and are commercially available.

### Example 1

This example provides a perovskite solar cell, and the preparation steps are as follows:
(1) An ITO conductive glass with a specification of 2.0 cm*2.0 cm was taken, 0.35 cm of ITO at both ends was removed by laser etching to expose the glass substrate; the etched ITO conductive glass was ultrasonically cleaned several times with water, acetone, and isopropyl alcohol in turn; the solvent of the ITO conductive glass was blow-dried under a nitrogen gun, and further cleaning was performed in a UV ozone machine.
(2) After spin coating of a 2 mg/mL poly (bis(4-phenyl) (2,4,6-trimethylphenyl)amine) (PTAA) organic hole transport layer was performed on the UV-ozone treated ITO substrate at a rate of 5000 rpm/s, annealing was performed on a hot plate at 100 °C for 10 min.
(3) Spin coating of the perovskite precursor solution was performed on the hole transport layer at 3000 rpm/s, followed by annealing at 100°C for 30 min and cooling to room temperature (20°C-30°C) to prepare a three-dimensional perovskite film on the surface of the hole transport layer. The perovskite precursor solution uses N,N-dimethylformamide and dimethyl sulfoxide in a volume ratio of 4:1 as solvent, contains 1.2 mol/L lead iodide, 1.0 mol/L formamidine hydroiodide and 0.2 mol/L cesium iodide, and the active material of the prepared perovskite film is FA_{0.83}Cs_{0.17}PbI₃(CsFA) system.
(4) The exposed surface of the perovskite film (except the surface in contact with the hole transport layer) was completely immersed in a mixed solvent (DMF/IPA/CB, volume ratio of 1:5: 1000, volume of 2uL: 10uL:2000uL respectively), treated at room temperature (20°C-30°C) for 10 min, taken out, and blown dry with nitrogen, and then the exposed surface was spin-coated at 4000 rpm for 30s with a compound providing A' ions (tetrafluorophenethylammonium iodide, CAS No.: 1413269-55-2, F-PEAI), and then annealed at 100°C for 30min to generate a two-dimensional perovskite. The active material of the two-dimensional perovskite is tetrafluorophenethylamine lead iodide perovskite material ((mF-PEA)₂PbI₃), and a 2D-3D perovskite layer was prepared.
(5) The 2D-3D perovskite layer was spin-coated with an electron transport layer ([6,6]-phenyl C₆₁butyric acid methyl ester (PCBM)) at 1200 rpm/s, annealed at 100 °C for 10 min, and then its passivation layer bathocuproine (BCP) was spin-coated at 5000 rpm/s.
(6) Metal electrode Ag was evaporated on the passivation layer, and the edge was cleaned for testing.

The perovskite solar cells provided in Examples 2 to 23 are the same as those in Example 1, with the main differences being shown in Table 1. Examples 22 and 23 change the thickness of two-dimensional and three-dimensional perovskites by controlling the rotational speed and time of spin coating of the compound providing A' ions.

The perovskite solar cell provided in the comparative example is the same as that in Example 1, except that the preparation method of the 2D-3D perovskite layer is as follows:
(1) An ITO conductive glass with a specification of 2.0 cm*2.0 cm was taken, 0.35 cm of ITO at both ends was removed by laser etching to expose the glass substrate; the etched ITO conductive glass was ultrasonically cleaned several times with water, acetone, and isopropyl alcohol in turn; the solvent of the ITO conductive glass was blow-dried under a nitrogen gun, and further cleaning was performed in a UV ozone machine.
(2) After spin coating of a 2 mg/mL poly (bis(4-phenyl) (2,4,6-trimethylphenyl)amine) (PTAA) organic hole transport layer was performed on the UV-ozone treated ITO substrate at a rate of 5000 rpm/s, annealing was performed on a hot plate at 100 °C for 10 min.
(3) Spin coating of the perovskite precursor solution was performed on the hole transport layer at 3000 rpm/s, followed by annealing at 100°C for 30 min and cooling to room temperature (20°C-30°C) to prepare a three-dimensional perovskite film on the surface of the hole transport layer. The perovskite precursor solution uses N,N-dimethylformamide and dimethyl sulfoxide in a volume ratio of 4:1 as solvent, contains 1.2 mol/L lead iodide, 1.0 mol/L formamidine hydroiodide and 0.2 mol/L cesium iodide, and the active material of the prepared perovskite film is FA_{0.83}Cs_{0.17}PbI₃(CsFA) system.
(4) The three-dimensional perovskite surface was spin-coated with a compound providing A' ions (phenylethylammonium iodide, CAS No.: 151059-43-7, PEAI) at 5000 rp/s for 30 s, followed by annealing at 100 °C for 10 min.
(5) The prepared perovskite film was spin-coated with an electron transport layer ([6,6]-phenyl C61 butyric acid methyl ester (PCBM)) at 1200 rpm/s, annealed at 100 °C for 10 min, and then its passivation layer bathocuproine (BCP) was spin-coated at 5000 rpm/s.
(6) Metal electrode Ag was evaporated on the passivation layer, and the edge was cleaned for testing.

### Test example:

### (1) Perovskite thickness test

The thickness of two-dimensional perovskite and three-dimensional perovskite was tested by ellipsometer and step profiler, and the results are recorded in Table 1.

### (2) Photoelectric conversion efficiency of perovskite solar cell

Under the irradiation of standard simulated sunlight (AM 1.5G, 100 mW/cm²), the battery performance was tested to obtain an I-V curve. The short-circuit current Jsc (in mA/cm²), the open-circuit voltage Voc (in V), the maximum light output current Jmpp (in mA) and the maximum light output voltage Vmpp (in V) can be obtained based on the I-V curve and the data fed back by the test equipment. The fill factor FF of the solar cell (in %) was calculated using the formula FF=Jsc×Voc/(Jmpp×Vmpp). The photoelectric conversion efficiency PCE (in %) of the solar cell was calculated by the formula PCE=Jsc×Voc×FF/Pw; Pw represents the input power, in mW.

### The results are shown in Table 2.

### (3) Stability test of perovskite solar cell

The prepared battery device was placed in a dry room in the dark for storage, wherein the humidity was about 5%. The device efficiency was retested after 100 days, and the ratio of the efficiency to the initial efficiency was calculated. The specific experimental results are shown in Table 2.

**Table 1**

| Exampl e | Activ e materi al in perov skite thin film | Compound that provides A'ion | Mixed solvent | Volume (uL) | Temperatur e and time of solvent treatment | Temper ature and time of annealin g treatme nt | 2D perov skite thickn ess (nm) | 3D perov skite thickn ess (nm) | 2D-3D thick ness ratio | X/ Y |
|---|---|---|---|---|---|---|---|---|---|---|
| 1 | CsFA | F-PEAI | DMF/IPA/CB | 2:10:20 00 | Room temperature *10min | 100°C* 30min | 5 | 620 | 0.8 : 100 | 0. 4 |
| 2 | MAP bI₃ | F-PEAI | DMF/IPA/CB | 2:10:20 00 | Room temperature *10min | 100°C* 30min | 5 | 620 | 0.8 : 100 | 0. 4 |
| 3 | FAPb I₃ | F-PEAI | DMF/IPA/CB | 2:10:20 00 | Room temperature *10min | 100°C* 30min | 5 | 620 | 0.8 : 100 | 0. 4 |
| 4 | CsFA | Octyl ammonium bromide | DMF/IPA/CB | 2:10:20 00 | Room temperature *10min | 100°C* 30min | 3 | 650 | 0.5 : 100 | 0. 7 |
| 5 | CsFA | N,N-Bis-2-chloroethyl p-toluenesulfonic acid amine | DMF/IPA/CB | 2:10:20 00 | Room temperature *10min | 100°C* 30min | 10 | 600 | 1.7: 100 | 0. 2 |
| 6 | CsFA | Cyclopentaneca rboxamide | DMF/IPA/CB | 2:10:20 00 | Room temperature *10min | 100°C* 30min | 16 | 580 | 2.7: 100 | 0. 1 |
| 7 | CsFA | F-PEAI | DMF/IPA/CB | 0.2:0.2: 2000 | Room temperature *10min | 100°C* 30min | 2 | 680 | 0.3: 100 | 0. 1 |
| 8 | CsFA | F-PEAI | DMF/IPA/CB | 10:20:2 000 | Room temperature *10min | 100°C* 30min | 28 | 500 | 5.6: 100 | 0. 3 |
| 9 | CsFA | F-PEAI | DMF/IPA/CB | 20:200: 2000 | Room temperature *10min | 100°C* 30min | 10 | 620 | 1.6 : 100 | 2 |
| 10 | CsFA | F-PEAI | DMSO/acetonit rile/anisole | 2:10:20 00 | Room temperature *10min | 100°C* 30min | 3 | 670 | 0.4: 100 | 0. 7 |
| 11 | CsFA | F-PEAI | NMP/acetonitril e/ethyl acetate | 2:10:20 00 | Room temperature *10min | 100°C* 30min | 10 | 650 | 1.5: 100 | 0. 2 |
| 12 | CsFA | F-PEAI | GLB/acetonitril e/CB | 2:10:20 00 | Room temperature *10min | 100°C* 30min | 14 | 640 | 2.2: 100 | 0. 1 |
| 13 | CsFA | F-PEAI | DMF/IPA/CB | 2:10:20 00 | Room temperature *1min | 100°C* 30min | 2 | 650 | 0.3: 100 | 1 |
| 14 | CsFA | F-PEAI | DMF/IPA/CB | 2:10:20 00 | Room temperature * 15min | 100°C* 30min | 6 | 680 | 0.9: 100 | 0. 33 |
| 15 | CsFA | F-PEAI | DMF/IPA/CB | 2:10:20 00 | Room temperature *40min | 100°C* 30min | 25 | 600 | 4: 100 | 0. 08 |
| 16 | CsFA | F-PEAI | DMF/IPA/CB | 2:10:20 00 | Room temperature *60min | 100°C* 30min | 38 | 380 | 10 : 100 | 0. 05 |
| 17 | CsFA | F-PEAI | DMF/IPA/CB | 2:10:20 00 | Room temperature *10min | 50°C*4 0min | 5 | 620 | 0.8 : 100 | 0. 4 |
| 18 | CsFA | F-PEAI | DMF/IPA/CB | 2:10:20 00 | Room temperature *10min | 150°C* 20min | 5 | 620 | 0.8 : 100 | 0. 4 |
| 19 | CsFA | F-PEAI | GLB/acetonitril e/CB | 4:20:40 00 | Room temperature *10min | 100°C* 30min | 50 | 890 | 5.6: 100 | 0. 08 |
| 20 | CsFA | F-PEAI | GLB/acetonitril e/CB | 4:20:40 00 | Room temperature *10min | 100°C* 30min | 40 | 1600 | 2.5: 100 | 0. 1 |
| 21 | CsFA | F-PEAI | NMP/acetonitril e/ethyl acetate | 4:20:40 00 | Room temperature *10min | 100°C* 30min | 40 | 2000 | 2: 100 | 0. 1 |
| 22 | CsFA | F-PEAI | DMF/IPA/CB | 2:10:20 00 | Room temperature *10min | 100°C* 30min | 2 | 1000 | **0.2: 100** | 0. 1 |
| 23 | CsFA | F-PEAI | DMF/IPA/CB | 2:10:20 00 | Room temperature *10min | 100°C* 30min | **1** | **300** | 0.33 100 | 0. 1 |
| Compa rative Exampl e | CsFA | PEAI | / | / | / | / | / | 620 | / | / |

The thickness of the two-dimensional perovskite in the comparative example is "/", which means that the prepared two-dimensional perovskite is discontinuous and it is difficult to obtain the thickness parameter.

**Table 2**

| | Jsc (mA cm⁻²) | Voc (V) | FF (%) | PCE (%) | Efficiency ratio to initial efficiency (%) |
|---|---|---|---|---|---|
| Example 1 | 23.55 | 1.09 | 75.47 | 19.37 | 91.5 |
| Example 2 | 20.04 | 1.05 | 71 | 14.94 | 61.2 |
| Example 3 | 23.47 | 1.04 | 72.38 | 17.67 | 87.3 |
| Example 4 | 23.48 | 1.04 | 70.84 | 17.30 | 85.2 |
| Example 5 | 23.65 | 1.04 | 72.52 | 17.84 | 79.8 |
| Example 6 | 23.58 | 1.03 | 68.94 | 16.74 | 77.8 |
| Example 7 | 22.48 | 0.984 | 71.74 | 15.87 | 73.2 |
| Example 8 | 20.52 | 0.94 | 70.47 | 13.59 | 69.1 |
| Example 9 | 22.61 | 1.03 | 72.7 | 16.93 | 70.3 |
| Example 10 | 23.08 | 1 | 72.84 | 16.81 | 71.9 |
| Example 11 | 23.15 | 1.02 | 70.52 | 16.65 | 77.2 |
| Example 12 | 23.18 | 1.03 | 71.94 | 17.18 | 75.5 |
| Example 13 | 23.47 | 1.08 | 75.1 | 19.04 | 81.4 |
| Example 14 | 23.58 | 1.09 | 74.2 | 19.07 | 90.5 |
| Example 15 | 23.15 | 1.08 | 69.2 | 17.30 | 91.4 |
| Example 16 | 23.18 | 1.06 | 54.6 | 13.42 | 92.3 |
| Example 17 | 23.4 | 1.09 | 74.44 | 18.99 | 90.1 |
| Example 18 | 23.15 | 1.08 | 76.07 | 19.02 | 89.3 |
| Example 19 | 22.08 | 1.09 | 67.04 | 16.13 | 78.5 |
| Example 20 | 21.78 | 1.08 | 63.9 | 15.03 | 79.9 |
| Example 21 | 21.15 | 1.08 | 55.52 | 12.68 | 81.2 |
| Example 22 | 23.71 | 1.08 | 73.32 | 18.77 | 82.0 |
| Example 23 | 23.42 | 1.07 | 74.21 | 18.60 | 73.5 |
| Comparative Example | 23.15 | 1.09 | 74.3 | 18.92 | 60.7 |

It can be seen that, compared with the comparative example, Examples 1 to 23 of the present application can achieve better device stability.

Furthermore, from the comparison between Examples 1 to 3, it can be seen that the stability of the device varies when the active materials of different perovskite films are used as the mother layer, among which CsFA and FAPbI₃ have better stability.

From the comparison between Examples 1 and 4 to 6, it can be seen that the stability of the device varies when the mother layer is ion-replaced with different compounds providing A' ions, among which the device prepared with F-PEAI and octylammonium bromide as the compounds providing A' ions has better stability.

From the comparison between Examples 1 and 7 to 9, it can be seen that by treating the mother layer with solvents in different proportions, two-dimensional perovskites of different thicknesses can be obtained, wherein the device prepared when the mother layer is treated with solvents in a ratio of 2:10:2000 has better stability.

From the comparison between Examples 1 and 10 to 12, it can be seen that two-dimensional perovskites of different thicknesses can be obtained by treating the mother layer with different types of solvents. The device prepared when the mother layer is treated with a combination of DMF/IPA/CB as solvent has better stability.

From the comparison between Examples 1 and 13 to 16, it can be seen that by subjecting the mother layer to solvent treatment for different times, two-dimensional perovskites of different thicknesses can be obtained, and as time goes by, the thickness of the two-dimensional perovskite increases accordingly, and the stability of the prepared device is also improved to a certain extent.

From the comparison between Examples 1 and 19 to 23, it can be seen that as the thickness ratio of the two-dimensional perovskite to the three-dimensional perovskite increases, the thickness of the prepared two-dimensional perovskite increases, and at the same time, the device stability decreases to a certain extent. Among them, in Example 23, due to the too small thinness of the three-dimensional perovskite, the device stability also decreases to a certain extent.

It should be noted that the present application is not limited to the above embodiments. The above-described embodiments are merely illustrative, and embodiments having substantively the same composition as the technical idea and exerting the same effects within the scope of the technical solution of the present application are all included in the technical scope of the present application. **In** addition, without departing from the scope of the subject matter of the present application, various modifications that can be conceived by those skilled in the art are applied to the embodiments, and other modes constructed by combining some of the constituent elements of the embodiments are also included in the scope of the present application.

## Claims

1. A perovskite solar cell, comprising a transparent electrode, a first functional layer, a perovskite layer, a second functional layer and a second electrode layer which are stacked, wherein the perovskite layer comprises a three-dimensional perovskite layer and a two-dimensional perovskite layer which are stacked, the surface of the three-dimensional perovskite layer in contact with the first functional layer being a first surface, and the remaining surfaces constituting a second surface, and the two-dimensional perovskite layer covers the entire second surface.

2. The perovskite solar cell according to claim 1, wherein the two-dimensional perovskite layer is of a continuous structure.

3. The perovskite solar cell according to any one of claims 1 to 2, wherein the general structural formula of the active material in the three-dimensional perovskite layer is ABX₃or A₂CDX₆; the general structural formula of the active material in the two-dimensional perovskite layer is A'BX₃or A'₂CDX₆;
the A' ion and the A ion comprise one or more monovalent cations, the B ion comprises one or more divalent metal cations, the C ion and the D ion comprise one or more monovalent metal cations and trivalent metal cations, respectively, and the X ion comprises one or more monovalent anions;
wherein the ionic radius of at least one monovalent cation in the A' ion is larger than the ionic radius of the monovalent cation in the A ion.

4. The perovskite solar cell according to any one of claims 1 to 3, wherein the thickness ratio of the two-dimensional perovskite layer to the three-dimensional perovskite layer is (0.2-10): 100.

5. The perovskite solar cell according to any one of claims 1 to 4, wherein the thickness of the two-dimensional perovskite layer is 1-50 nm; optionally, the thickness of the two-dimensional perovskite layer is 2-32 nm.

6. The perovskite solar cell according to any one of claims 1 to 5, wherein the thickness of the three-dimensional perovskite layer is 300-2000nm.

7. The perovskite solar cell according to any one of claims 3 to 6, wherein the A' ion comprises organic amine ions; optionally, the A' ion has the following structural features: (R)₄N⁺, wherein R each independently comprises H, at least one R₀ substituted or unsubstituted C1-C20 alkyl, C1-C20 alkenyl, C3-C10 cycloalkyl, R₀C(O)-, R₀C(O)O-, R₀S(O)₂-, thiol, sulfonic acid group, phosphoric acid group or C6-C10 aryl, wherein R₀ each independently comprises: H, C1-C10 alkyl, C6-C10 aryl, halogen-substituted C6-C10 aryl, C1-C5 alkyl-substituted C6-C10 aryl, halogen, C3-C10 cycloalkyl or boronic acid group.

8. The perovskite solar cell according to any one of claims 3 to 7, having at least one of the following features:
(1) the A ion comprises one or more of organic amine ions, Li⁺, Na⁺, K⁺, Rb⁺ and Cs⁺; optionally, the A ion comprises one or more of organic amine ions and Cs⁺;
(2) the B ion comprises one or more of Pb²⁺, Sn²⁺, Be²⁺, Mg²⁺, Ca²⁺, Sr²⁺, Ba²⁺, Zn²⁺, Ge²⁺, Fe²⁺, Co²⁺ and Ni²⁺; optionally, the B ion comprises one or both of Pb²⁺ and Sn²⁺;
(3) the C ion comprises one or more of Cs⁺, Ag⁺, K⁺ and Ru⁺;
(4) the D ions comprises one or more of Bi³⁺, Ni³⁺, Fe³⁺ and Cu³⁺;
(5) the X ion comprises one or more of F⁻, Cl⁻, Br⁻and I⁻; optionally, the X ion comprises one or more of Cl⁻, Br⁻and I⁻.

9. The perovskite solar cell according to any one of claims 1 to 8, wherein the active material of the three-dimensional perovskite layer comprises one or more of CH₃NH₃PbI₃, CH(NH₂)₂PbI₃, FA_{0.83}Cs_{0.17}PbI₃, CsPbI₃, CsPbI₂Br and CsPbIBr₂.

10. The perovskite solar cell according to any one of claims 1 to 8, wherein the active material of the two-dimensional perovskite layer comprises one or more of (PEA)₂PbI₃, (PBA)₂PbI₃, (OAm)₂PbI₃, (mF-PEA)₂PbI₃ and (PD)₂PbI₃.

11. A method for preparing a perovskite solar cell, comprising the steps of:
preparing a first functional layer on the surface of a transparent electrode;
preparing a perovskite layer on the surface of the first functional layer, wherein the perovskite layer comprises a three-dimensional perovskite layer and a two-dimensional perovskite layer which are stacked, the surface of the three-dimensional perovskite layer in contact with the first functional layer is a first surface, the remaining surfaces constitute a second surface, and the two-dimensional perovskite layer covers the entire second surface;
preparing a second functional layer on the surface of the perovskite layer; and
preparing a second electrode layer on the surface of the second functional layer.

12. The method for preparing a perovskite solar cell according to claim 11, wherein the method for preparing the perovskite layer comprises the steps of:
preparing a three-dimensional perovskite mother layer on the surface of the first functional layer, wherein the general structural formula of the active material of the three-dimensional perovskite mother layer is ABX₃or A₂CDX₆;
performing solvent treatment on the surface of the three-dimensional perovskite mother layer corresponding to the second surface by means of a mixed solvent; and
reacting the three-dimensional perovskite mother layer after solvent treatment with a compound providing A'ions to generate the two-dimensional perovskite layer, wherein the general structural formula of the active material of the two-dimensional perovskite layer is general structural formula of A'BX₃or A'₂CDX₆;
the A' ion and the A ion comprise one or more monovalent cations, the B ion comprises one or more divalent metal cations, the C ion and the D ion comprise one or more monovalent metal cations and trivalent metal cations, respectively, and the X ion comprises one or more monovalent anions;
wherein the ionic radius of at least one monovalent cation in the A' ion is larger than the ionic radius of the monovalent cation in the A ion.

13. The method for preparing a perovskite solar cell according to claim 12, wherein the mixed solvent comprises a combination of a first solvent, a second solvent and a third solvent;
the first solvent comprises one or more solvents used for preparing a precursor solution of the three-dimensional perovskite mother layer; optionally, the first solvent comprises one or more of amine, sulfone, sulfoxide, ester and ketone solvents; further optionally, the first solvent comprises one or more of dimethylformamide, dimethyl sulfoxide, N-methyl pyrrolidone and γ-butyrolactone;
the second solvent comprises a solvent that can dissolve A ions but cannot dissolve BX₂, or the second solvent comprises a solvent that can dissolve A ions but cannot dissolve CDX₄; optionally, the second solvent comprises one or more of alcohol, nitrile and ketone solvents; further optionally, the second solvent comprises one or more of isopropanol, ethanol, methanol, acetone and acetonitrile;
the third solvent comprises one or more anti-solvents used for preparing the three-dimensional perovskite mother layer; optionally, the third solvent comprises one or more of aromatic hydrocarbon, ether and ester solvents; further optionally, the third solvent comprises one or more of chlorobenzene, anisole, ethyl ether and ethyl acetate.

14. The method for preparing a perovskite solar cell according to claim 12 or 13, wherein the mixed solvent has at least one of the following features:
(1) the first solvent is 0.01% to 1% by volume of the third solvent;
(2) the second solvent is 0.01% to 10% by volume of the third solvent;
(3) the volume ratio of the first solvent to the second solvent is (0.1-1):1.

15. The method for preparing a perovskite solar cell according to any one of claims 12 to 14, wherein the condition for solvent treatment has at least one of the following features:
(1) the solvent treatment time is 1min-60min;
(2) the temperature of the mixed solvent used in the solvent treatment is 20°C-30°C;
(3) the amount of the first solvent used is X µL, the thickness of the two-dimensional perovskite layer is Y nm, and X and Y satisfy 0.05<X/Y<5.

16. The method for preparing a perovskite solar cell according to any one of claims 12 to 15, wherein the condition for reacting the three-dimensional perovskite mother layer after solvent treatment with the compound providing A' ions comprises: annealing at a temperature of 50°C to 150°C; optionally, the annealing time is 20min to 40min.

17. The method for preparing a perovskite solar cell according to any one of claims 12 to 16, wherein the compound providing the A' ions comprises one or more of the following compounds and their salts: CH₃CH₂CH₂CH₂CH₂CH₂CH₂CH₂NH₂, CH₃CH₂CH₂CH₂CONH₂, CH₃CH₂CH₂CH₂COONH₂, phenethylamine, benzylamine, amphetamine, fluorophenethylamine, fluorophenethylamine iodide, phenylboronic acid amine, oleylamine, octylammonium bromide, N,N-bis(2-chloroethyl)-p-toluenesulfonic acid amine and cyclopentanecarboxamide.

18. An electrical apparatus, comprising at least one of the perovskite solar cell according to any one of claims 1 to 10 and the perovskite solar cell prepared by the preparation method according to any one of claims 11 to 17.
